Europäisches Patentamt

European Patent Office

Office européen des brevets

(11) Veröffentlichungsnummer : **0 050 818**
**B1**

# (12) EUROPÄISCHE PATENTSCHRIFT

(45) Veröffentlichungstag der Patentschrift :
28.08.85

(21) Anmeldenummer : **81108491.2**

(22) Anmeldetag : **19.10.81**

(51) Int. Cl.⁴ : **G 03 F  7/26, G 03 D  3/00**

(54) **Entwicklungsgerät.**

(30) Priorität : **28.10.80 DEU 8028682**

(43) Veröffentlichungstag der Anmeldung :
**05.05.82 Patentblatt 82/18**

(45) Bekanntmachung des Hinweises auf die Patenterteilung : **28.08.85 Patentblatt 85/35**

(84) Benannte Vertragsstaaten :
**BE CH DE FR GB IT LI NL SE**

(56) Entgegenhaltungen :
**DE-A- 1 772 179
DE-A- 1 961 409
DE-A- 2 319 140
US-A- 3 916 426
US-A- 4 179 208
Prospekt der Firma Cornerstone (Minilith Processor)
Prospekt der Firma Dr. Böger Duplomat KG (CP370)**

(73) Patentinhaber : **HOECHST AKTIENGESELLSCHAFT**
**Postfach 80 03 20**
**D-6230 Frankfurt am Main 80 (DE)**

(72) Erfinder : **Schörnig, Eberhard**
**Römerstrasse 9**
**D-6204 Taunusstein 4 (DE)**
Erfinder : **Kümmerl, Klaus**
**Kohlenhofstrasse 60**
**D-8500 Nürnberg (DE)**

## Beschreibung

Die Erfindung betrifft ein Entwicklungsgerät für blattförmiges Material, insbesondere für biegsame Druckplatten, bestehend aus einer Zweiwannenkombination mit Trennsteg, mit einer Entwicklerwanne und einer Nachbehandlungswanne und mit herausnehmbaren Einsätzen für Einlaufwalzenpaare und Auslaufwalzenpaare aufweisende Transport- und Führungsmittel zum bogenförmigen Führen des Materials durch Bäder der Behandlungsflüssigkeiten.

Entwicklungsgeräte mit sogenannten muldenförmigen Tauchbädern in Zweiwannenkombination sind bekannt. Sie sind im allgemeinen als Tischdurchlaufgeräte oder als Standgeräte zur vollautomatischen Entwicklung von Fotopapieren oder zum Beispiel auch im Kleinoffsetbereich einsetzbar (wie zum Beispiel das im Handel befindliche Plattenentwicklungsgerät MINILITH PROCESSOR der Firma Cornestone (GB) oder das Gerät CP 370 der Firma Dr. Böger Duplomat KG, Hamburg).

Es ist auch ein Entwicklungsgerät ohne muldenförmige Bodenanordnung bekannt (DE-A 17 72 179), das bei fest angeordneten Transport- und Führungsmitteln eine rotierende Wischvorrichtung mit einer porösen, elastischen, weich arbeitenden, mittig zwischen den Ein- und Auslaufwalzenpaaren angeordneten Wischfläche zum Abwaschen von zum Beispiel löslich gebliebenen Stellen besitzt. Zur Entwicklung wird eine luftschöpfende Sprühbehandlung unter einer Spritzplatte vorgenommen, die die abspritzende Flüssigkeit auffängt. Die Behandlungsflüssigkeit wird in einer unterhalb der Behandlungszone angeordneten Auffangwanne gesammelt.

Es ist ferner aus DE-A 19 61 409 eine Vorrichtung zum Behandeln von Druckplatten mit Flüssigkeiten bekannt, bei der beiderseits oberhalb mindestens einer Wanne zwei angetriebene Walzenpaare angeordnet sind, wobei die durch die Achsen der beiden Walzenpaare gehenden Geraden einen nach unten offenen Winkel bilden, zwischen dessen Schenkeln eine flachmuldenförmige Führungsbahn für die zu behandelnde Druckplatte angeordnet ist. Die Führungsbahn wird durch in der Wanne befindliche Walzen gebildet. Zur Bearbeitung können Mittel wie Bürstenwalzen, Rakel oder Schwämme benutzt werden. Diese Mittel sind so angeordnet, daß durch ihren Betrieb das Einbringen von Luft nicht verhindert wird.

Die bekannten Geräte besitzen schwerwiegende Nachteile. So erhält man zum Beispiel nach dem Durchlauf unerwünscht gekrümmte Materialien, wie Platten, die teilweise auch noch störende Kratzer vorder- und/oder rückseitig besitzen. Ferner ist die Ausentwicklung nicht in allen Fällen befriedigend. Behandlungsbäder oder die Behandlungszone beginnen auch nach gewisser Gebrauchsdauer zu schäumen, so daß die Behandlung abgebrochen werden muß. Zum Beheben dieses Nachteils muß man entweder den Entwickler wechseln, Antischaummittel zufügen oder eine kleinere Verarbeitungsgeschwindigkeit einstellen. Behandelte Materialien werden gelegentlich auch noch feucht und nicht genügend abgequetscht zur Verfügung gestellt, was in diesen Fällen eine besondere Trocknung erfordert.

Es war Aufgabe der Erfindung, die beschriebenen Mängel bei einem Entwicklungsgerät mit Zweiwannenkombination zu vermeiden und ein Gerät zur Verfügung zu stellen, welches eine problemlose, standardisierte Entwicklung und Nachbehandlung, wie Wässern oder Konservieren, ermöglicht und welches die Herstellung von zum Beispiel Druckplatten gestattet, die höchsten Ansprüchen genügen.

Die Lösung dieser Aufgabe geht von einem Gerät der eingangs genannten Art aus und ist dadurch gekennzeichnet, daß vor dem Auslaufbereich der Entwicklerwanne oberhalb der Transportbahn des Materials und teilweise unter dem Flüssigkeitsniveau eine rotierende Bürstwalze mit federnd gelagerter, auf der anderen Seite der Transportbahn befindlicher Gegenwalze angeordnet ist, daß die Bürstwalze durch eine Schutzhaube abgedeckt ist, deren, in Durchlaufrichtung gesehen, hintere Unterkante sich bis unter das Entwicklerflüssigkeitsniveau erstreckt, und daß für den Transport des Materials durch die Wannen neben den Einlaufwalzenpaaren und den Auslaufwalzenpaaren schichtseitig drehbare Umlenkrollen und rückseitig feststehende Führungsflächen vorgesehen sind. Das erfindungsgemäße Entwicklungsgerät besitzt insbesondere im Übergangsbereich von Entwicklerwanne und Nachbehandlungswanne eine solche Anordnung, daß das Auslaufwalzenpaar der Entwicklerwanne und das Einlaufwalzenpaar der Nachbehandlungswanne so angeordnet sind, daß mit Hilfe von Umlenkrollen das Material rückseitig den Trennsteg nicht flächig streift.

Hierdurch wid erreicht, daß ein einfaches, wenig aufwendiges und wenig störanfälliges Entwicklungsgerät zur Verfügung gestellt werden kann, welches bei schonender Behandlung des zu entwickelnden Materials einwandfrei arbeitet und eine längere Gebrauchsdauer der Bäder ermöglicht. Insbesondere bei feinen Rasterflächen bietet das erfindungsgemäße Entwicklungsgerät ausgezeichnete Ausentwicklung.

Durch die flächenhafte Vergrößerung eines ursprünglichen Bürstenspritzschutzes zur Schutzhaube und Verlängern der auslaufseitigen Hinterkante bis unter das Badniveau wird einmal das Luftschöpfen der Bürste verhindert, was sonst zur Schaumbildung führt. Zum anderen wird die Badoberfläche wesentlich verkleinert, wodurch die Gebrauchsdauer des Entwicklers, zum Beispiel infolge geringerer Sauerstoff- oder Kohlendioxidaufnahme aus der Luft, erhöht und gleichzeitig die Menge an notwendiger Entwicklerflüssigkeit vermindert wird, da die Schutzhaube auch als Flüssigkeitsverdrängerkörper dient. Hierdurch wird auch das Verhältnis der Badinhalte von entwickler- und Nachbehandlungsbad günstif beeinflußt. Es hat sich gezeigt, daß zum Beispiel eine Entwicklerfüllung auf zwei Füllungen des Nachbehandlungsbades vorteilhaft ist. Die Führung des zu behandelnden Materials erfolgt so, daß bei dem bogenförmigen Führen schichtseitig eine flächige Berührung des Materials nur an drehbaren Rollen erfolgt und rückseitig das Material lediglich kantenweise von den Führungsmitteln berührt und geleitet wird. Damit wird eine schonende Behandlung des Materials gewährleistet, das ohne nachteilige Oberflächenveränderung oder Verformung das erfindungsgemäße Entwicklungsgerät verläßt.

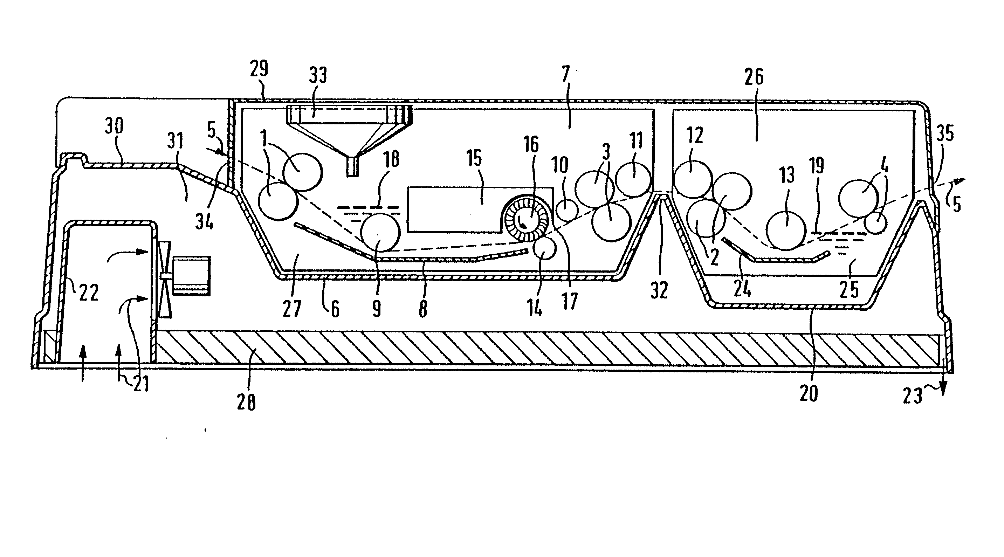

Die Erfindung wird anhand der beigefügten Figur näher erläutert, die einen schematischen Längsschnitt durch das Entwicklungsgerät darstellt.

Das Entwicklungsgerät besteht aus der Abdeckhaube 29 und dem Wannenunterteil 30, welches die Wannen 6 und 20 enthält, die, im wesentlichen, über dem Motorraum 31 mit Luftführungskanal 22 und über der Grundplatte 28 angeordnet sind. Das zu behandelnde blattförmige Material, zum Beispiel eine bildmäßig belichtete Druckplatte oder eine solche mit fixiertem Tonerbild und mit metallischem oder nicht-metallischem Träger, wie Aluminium, Papier oder Kunststoffolie, wird mit der Schichtseite nach oben in Pfeilrichtung 5 durch einen Einführschlitz 34 in das Gerät eingebracht. Das Einlaufwalzenpaar erfaßt die Materialvorderkante und führt das Material zwischen der Umlenkrolle 9 und dem Führungsmittel 8, welches ein oberflächlich glattes oder strukturiertes Blech darstellen kann, durch das Bad 27. Als Entwicklermedium können Lösungen, die anorganische und-/oder organische alkalische Substanzen in Wasser und/oder organischen Lösungsmitteln enthalten, verwendet werden, so daß neben der üblichen Entwicklung auch zum Beispiel die Entschichtung von auf elektrophotographischem Wege hergestellten tonerbildfixierten Schichten in dem Gerät nach der Erfindung erfolgen kann. Nach Passieren von etwa zwei Dritteln der Wegstrecke wird im Auslaufbereich eine Bürstwalze 16 erreicht, welche vorzugsweise völlig mit Borstbüscheln besetzt ist und vorzugsweise in Durchlaufrichtung rotiert. Die Effizienz der Bürstung, besonders bei feinen Rasterflächen, ist durch diese Anordnung besonders groß. Die Faserdicke der Borsten kann zum Beispiel 0,1 mm betragen und das Material kann, je nach Verwendungsweck, weich, zum Beispiel aus Polypropylen, oder härter eingestellt sein. Die Borstbüschel sind vorzugsweise wendelförmig angebracht. Die Anordnung der Büschel dient nicht nur zur guten Ausentwicklung, sondern auch dazu, eine Badumwälzung zu bewirken. Das vorgeweichte Material wird zwischen der rotierenden Bürstwalze 16 und der federnd gelagerten Gegenwalze 14 mechanisch ausentwickelt. Die federnd gelagerte Gegenwalze 14 bewirkt bei unterschiedlich dicken Materialien im wesentlichen einen gleichbleibenden Anpreßdruck zwischen Bürstwalze 16 und dem Material. Anschließend wird das Material zu dem Auslaufwalzenpaar 3 geleitet. Dabei hindert die hinter der Bürstwalze 16 angeordnete Rolle 10, insbesondere bei dünnerem Material, das Umbiegen der Materialhinterkante durch die Bürstwalze 16. Die Bürstwalze 16 selbst kann in erhöhter Geschwindigkeit gegenüber der Transportgeschwindigkeit laufen, was bevorzugt ist. Sie kann jedoch auch gegenläufig rotieren. Die Bürstwalze 16 ist durch eine Schutzhaube 15 abgedeckt, welche, in Durchlaufrichtung 5 gesehen, mit ihrer hinteren Unterkante 17 in die Flüssigkeit eintaucht. Die Schutzhaube 15 ist als Verdrängerkörper für die Flüssigkeit gearbeitet und kann die Flüssigkeitsoberfläche bis zu etwa zwei Dritteln verminder, wobei jedoch der Raum unter der Schutzhaube völlig mit Flüssigkeit gefüllt ist. Das Auslaufwalzenpaar 3 ist mit einer weichen Gummibeschichtung versehen, die eine Shorehärte im Bereich von etwa 20 bis 50°, vorzugsweise 30 bis 40°, besitzt. Das Auslaufwalzenpaar 3 befreit das Material weitgehendst von anhaftender Flüssigkeit. Die Umlenkrollen 11 und 12 dienen im Zusammenspiel mit dem Auslaufwalzenpaar 3 und dem Einlaufwalzenpaar 2 der Überleitung des Materials in das Nachbehandlungsbad 25, wobei ein rückseitiges Streifen des Materials über den Trennsteg 32 vermieden wird. Das Nachbehandlungsbad 25 dient dem Wässern oder Konservieren des Materials nach dem Tauchbadprinzip. Dabei erfaßt das Einlaufwalzenpaar 2 die Materialvorderkante und führt das Material durch das Bad zwischen dem gegebenenfalls oberflächlich strukturierten Führungsmittel 24, zum Beispiel einem Blech, und der Umlenkrolle 13. Auslaufseitig erfolgt ein intensives Abquetschen mit Hilfe des Auslaufwalzenpaares 4, wobei die Walzen entsprechend den Auslaufwalzen 3 geartet sind. Im Falle, daß die untere Walze des Walzenpaares 4 das Badniveau 19 nicht berühren soll, kanne sie mit kleinerem Durchmesser als die obere Walze gearbeitet sein. Nach dem Abquetschen läuft das Material aus dem erfindungsgemäßen Gerät durch Auslaufschlitz 35 aus und wird auf einen (nicht gezeigten) Auslauftisch geschoben.

Das Füllen der Wannen wird vorzugsweise durch einen Trichter 33 vorgenommen. An treppenförmigen Füllstandsmarken wird der richtige Füllstand kontrolliert. Die Wanne 6 kann zusätzlich mit einer (nicht gezeigten) Heizung, zum Beispiel einer Bodenheizung, versehen sein, was die Entwicklung günstig beeinflussen mag.

Unterhalb des Wannenunterteils 30 und einlaufseitig vor dem Entwicklerteil ist der Motorraum 31 angeordnet. Damit erwünschtenfalls kein Erwärmung der Bäder durch die Motorwärme eintritt, kann ein Luftführungskanal 22 ausgehend von einer Öffnung 21 in der Grundplatte 28 vorgesehen sein. Der Lufteintritt bewirkt dann eine Belüftung des Zwischenraums zwischen Wannenunterteil 30 und der Grundplatte 28. Der Austritt der erwärmten Kühlluft befindet sich zum Beispiel bei 23 oder an jeder anderen Stelle der Grundplatte, vorzugsweise in den Eckenbereichen.

Die behandelten Materialien sind im allgemeinen, nachdem sie das Entwicklungsgerät verlassen haben, bei normalen Raumbedingungen in etwa 1/2 bis 1 Minute trocken und zur Weiterbearbeitung geeignet. Sie zeigen keinerlei störende Wölbung, da die Planlage des Materials beim Gerätedurchlauf unverändert bleibt.

Zweckmäßigerweise enthalten die Ensätze der Bäder 27 und 25 in den jeweiligen Seitenteilen 7 und 26 alle Einbauten, wie Walzen, Bürste, Zahnradantriebe, Führungsmittel, Schutzhaube. Zur Reinigung können die Bäder mit Hilfe üblicher Ablaßeinrichtungen entleert werden. Die Einsätze können dann durch verschiebbare Muffenkupplungen vom Antrieb seitlich am Wannenunterteil getrennt und einzeln entnommen werden. Dies ist besonders für Reinigungszwecke von großem Vorteil, wobei noch dafür gesorgt ist, daß die Wannen gerundete Kanten besitzen, wodurch die Reinigung zum Beispiel mit einem Schwamm noch weiter erleichtert wird. Durch die herausnehmbaren Einsätze kann die Reinigung in einem Becken, zum Beispiel durch Abbrausen mit Wasser, besonders einfach gestaltet werden.

Vorzugsweise wird der Antrieb der Bürstwalze 16 wie auch der aller Transportwalzen eines Bades von je einer Welle abgeleitet. Die Drehbewegung wird mit Kunststoffzahnrädern übertragen. Die Kunststoffzahnräder, die vorzugsweise jeweils an einer Einsatzseite angeordnet sind, werden vorteilhaft und aus Sicherheitsgründen mit glattflächigen Kunststoffteilen abgedeckt.

Die Transportgeschwindigkeit, im Bereich von beispielsweise 0,1 bis etwa 1m/min, ist stufenlos einstellbar, um unterschiedliche Verweilzeiten in Abhängigkeit vom Materialtyp, der Temperatur des Badinhalts und der Gebrauchsfähigkeit des Badinhaltes vornehmen zu können.

**Patentansprüche**

1. Entwicklungsgerät für blattförmiges Material, insbesondere für biegsame Druckplatten, bestehend aus einer Zweiwannenkombination mit Trennsteg, mit einer Entwicklerwanne und einer Nachbehandlungswanne und mit herausnehmbaren Einsätzen für Einlaufwalzenpaare und Auslaufwalzenpaare aufweisende Transport- und Führungsmittel zum bogenförmigen Führen des Materials durch Bäder der Behandlungsflüssigkeiten, dadurch gekennzeichnet, daß vor dem Auslaufbereich der Entwicklerwanne (6) oberhalb der Transportbahn des Materials und teilweise unter dem Flüssigkeitsniveau (18) eine rotierende Bürstwalze (16) mit federnd gelagerter, auf der anderen Seite der Transportbahn befindlicher Gegenwalze (14) angeordnet ist, daß die Bürstwalze (16) durch eine Schutzhaube (15) abgedeckt ist, deren, in Durchlaufrichtung (5) gesehen, hintere Unterkante (17) sich bis unter das Entwicklerflüssigkeitsniveau (18) erstreckt, und daß für den Transport des Materials durch die Wannen (6, 20) neben den Einlaufwalzenpaaren (1, 2) und den Auslaufwalzenpaaren (3, 4) schichtseitig drehbare Umlenkrollen (9 bis 13) und rückseitig feststehende Führungsflächen (8, 24) vorgesehen sind.

2. Gerät nach Anspruch 1, dadurch gekennzeichnet, daß das Auslaufwalzenpaar (3) der Entwicklerwanne und das Einlaufwalzenpaar (2) der Nachbehandlungswanne so angeordnet sind, daß mit Hilfe von Umlenkrollen (11, 12) das Material rückseitig den Trennsteg (32) nicht flächig streift.

3. Gerät nach Ansprüchen 1 und 2, dadurch gekennzeichnet, daß zur mechanischen Unterstützung der Entwicklung die Oberfläche der rotierenden Bürstwalze (16) völlig mit Borstbüscheln besetzt ist.

4. Gerät nach Ansprüchen 1 und 2, dadurch gekennzeichnet, daß die Bürstwalze (16) oberflächlich mit wendelförmigem Borstbesatz ausgestattet ist.

**Claims**

1. Developing apparatus for sheet material, particularly for flexible printing plates, comprising a double-tank combination with a separating web, a developing tank and an aftertreating tank equipped with removable inserts for transport and guide means including pairs of feed rollers and discharge rollers which convey the material on a curved path through the bathes of processing liquids, characterized in that a rotatable brush roller (16) and an elastically supported counter roller (14) provided at the other side of the transport path are arranged before the discharge area of the developing tank (6) above the transport path of the material and partially below the liquid level (18), said brush roller (16) is covered by a protective hood (15), the rear bottom edge (17) of said protective hood (15), as viewed in the direction of travel (5) extending below the level of the developer liquid, and that rotatable deviating rollers (9-13) at the coated side of the material and stationary guide means (8, 24) at the reverse side of the material besides pairs of feed rollers (1, 2) and discharge rollers (3, 4) are provided for transporting the material through said tanks (6, 20).

2. Apparatus according to claim 1, characterized in that the pair of discharge rollers (3) of the developing tank and the pair of feed rollers (2) of the aftertreating tank are arranged in such a manner that, with the aid of deviating rollers (11, 12) the reverse side of the material is not dragged over the separating web (32).

3. Apparatus according to claims 1 and 2, characterized in that the surface of the rotating brush roller (16) is completely covered with clusters of bristles, to mechanically assist development.

4. Apparatus according to claims 1 and 2, characterized in that the surface of the brush roller (16) is fitted with helically arranged bristles.

## Revendications

1. Appareil de développement pour matière en forme de feuille, en particulier pour plaques d'impression flexibles, composé d'un combiné à deux bacs avec une cloison, comprenant un bac de révélateur et un bac de post-traitement, et des garnitures amovibles pour des moyens de transport et de guidage, comprenant des paires de rouleaux d'entrée et des paires de rouleaux de sortie, pour le guidage en forme d'arc de la matière à travers des bains de liquides de traitement, caractérisé en ce qu'en amont de la région de sortie du bac de révélateur (6), est disposé au-dessus du couloir de transport de la matière et en partie au-dessous du niveau (18) du liquide, un rouleau brosse rotatif (16) avec un contre-rouleau (14) supporté élastiquement, qui se trouve de l'autre côté du couloir de transport, en ce que le rouleau brosse (16) est recouvert d'un capot de protection (15) dont le bord inférieur arrière (17), considéré dans le sens du passage (5), se prolonge jusqu'au-dessous du niveau du liquide révélateur (18), et en ce que, pour le transport de la matière à travers les bacs (6, 20), sont prévus, en supplément des paires de rouleaux d'entrée (1, 2) et des paires de rouleaux de sortie (3, 4) du côté couche sensible, des rouleaux de renvoi rotatifs (9 à 13) et du côté arrière des surfaces de guidage fixes (8, 24).

2. Appareil selon la revendication 1, caractérisé en ce que la paire de rouleaux de sortie (3) du bac de révélateur et la paire de rouleaux d'entrée (2) du bac de post-traitement sont disposées de manière que, grâce à des rouleaux de renvoi (11, 12), la matière ne frotte pas à plat sur la cloison (32) par sa face arrière.

3. Appareil selon les revendications 1 et 2, caractérisé en ce que, pour favoriser mécaniquement le développement, la surface du rouleau brosse rotatif (16) est entièrement garnie de touffes de soies.

4. Appareil selon les revendications 1 et 2, caractérisé en ce que le rouleau brosse (16) est équipé en surface d'une garniture de soies de forme hélicoïdale.